# EUROPÄISCHE PATENTANMELDUNG

(11) **EP 4 361 313 A1**
(43) Veröffentlichungstag der Anmeldung: **01.05.2024**
(21) Anmeldenummer: 22204401.8
(22) Anmeldetag: 28.10.2022
(51) Int. Cl.: C23C 16/458, C30B 25/12, H01L 21/687

(54) **MEHRTEILIGER SUSZEPTOR**

(71) Anmelder: Siltronic AG, 81677 München (DE)
(72) Erfinder: Edmaier, Walter, 84384 Wittibreut (DE); Hager, Christian, 84556 Kastl (DE); Stettner, Thomas, 83329 Waging am See (DE)
(74) Vertreter: Grundner, Sebastian

(57) **Zusammenfassung**

Suszeptor für eine Vorrichtung zum Abscheiden einer Schicht aus Halbleitermaterial auf einer Substratscheibe mittels Abscheidung aus der Gasphase, wobei der Suszeptor eine Suszeptorplatte und einen Trägerring für eine Substratscheibe umfasst, und der Trägerring auf der Suszeptorplatte angeordnet ist, dadurch gekennzeichnet, dass zwischen dem Trägerring und der Suszeptorplatte eine reversibel herstellbare und lösbare mechanische Verbindung besteht.

## Beschreibung

Gegenstand der Erfindung ist ein Suszeptor für eine Vorrichtung zum Abscheiden einer Schicht aus Halbleitermaterial auf einer Substratscheibe mittels Abscheidung aus der Gasphase und ein Verfahren zum Abscheiden einer Schicht aus Halbleitermaterial auf einer Substratscheibe, dadurch gekennzeichnet, dass der Suszeptor verwendet wird.

Das Abscheiden einer Schicht aus Halbleitermaterial auf einer Substratscheibe mittels chemischer Gasphasenabscheidung ("Chemical Vapor Deposition", CVD) erfolgt üblicherweise in der Prozesskammer einer Abscheidevorrichtung, die eine Substratscheibe aufnehmen kann. Während des Abscheidens der, vorzugsweise epitaktischen, Schicht liegt die Substratscheibe auf einem Suszeptor und wird durch eine Heizeinrichtung in der Prozesskammer auf die Abscheidetemperatur gebracht.

DE 10 2006 055 038 A1 beschreibt, dass bei der chemischer Gasphasenabscheidung einer Schicht aus Halbleitermaterial auf einer Substratscheibe, insbesondere beim Abscheiden einer epitaktischen Schicht auf einer polierten Halbleiterscheibe, unter anderem zwei unerwünschte Phänomene auftreten, die unter den Begriffen "autodoping" und "halo" bekannt sind.

Beim "autodoping" gelangen Dotierstoffe zunächst von der Rückseite einer hochdotierten Halbleiterscheibe über die Gasphase in das Abscheidegas und werden dann schließlich überwiegend im Randbereich der Vorderseite der Halbleiterscheibe in die epitaktische Schicht eingebaut. Dadurch wird eine unerwünschte radiale Schwankung des spezifischen Widerstands der epitaktischen Schicht hervorgerufen.

Mit "halo" wird ein Streulichteffekt bezeichnet, der durch Licht streuende Strukturen auf der Rückseite der Halbleiterscheibe hervorgerufen wird. Diese Strukturen markieren Übergänge auf der Oberfläche der Rückseite der Halbleiterscheibe, an denen Bereiche mit nativer Oxidschicht an Bereiche ohne eine solche Oxidschicht angrenzen. Diese Übergänge treten auf, wenn das Entfernen der nativen Oxidschicht während der Vorbehandlung in Wasserstoffatmosphäre ("pre-bake") vor der eigentlichen epitaktischen Abscheidung unvollständig war.

Die DE 10 2006 055 038 A1 löst diese Probleme durch Verwendung eines Suszeptors mit gasdurchlässiger Struktur. Durch die gasdurchlässige Struktur des Suszeptors können die während der Vorbehandlung in Wasserstoffatmosphäre entstehenden Reaktionsprodukte sowie die aus der Halbleiterscheibe diffundierenden Dotierstoffe zur Rückseite des Suszeptors gelangen und dort mittels eines Spülgasstromes aus dem Reaktor entfernt werden.

Ein weiteres Problem sind die durch die hohen Vorbehandlungs- und Abscheidetemperaturen hervorgerufenen thermischen Spannungen in der beschichteten Halbleiterscheibe. Wie die DE 10 2006 055 038 A1 beschreibt, können thermische Spannungen in der Halbleiterscheibe durch einen auf dem Suszeptor aufliegenden Ring vermieden werden, der als Wärmepuffer zwischen Suszeptor und Halbleiterscheibe wirkt.

Die DE 10 2017 206 671 A1 beschreibt einen solchen zweiteiligen Suszeptor, bei dem der Suszeptorring eine Ablagefläche (ledge) zum Ablegen einer Halbleiterscheibe im Randbereich der Rückseite der Halbleiterscheibe und eine an die Ablagefläche angrenzende stufenförmige äußere Begrenzung umfasst.

Jedoch führt die Verwendung eines separaten aufliegenden Rings zu Problemen, die insbesondere bei der Beschichtung von Dummy-Wafern auftreten. Dummy-Wafer sind Test-Wafer, die häufig zu Testzwecken zu Beginn eines neuen Produktionsprozesses, bei der Anpassung des Produktionsprozesses und zur Prozessüberwachung verwendet werden.

Beim Abscheiden einer epitaktischen Halbleiterschicht auf einem solchen Dummy-Wafer wird beobachtet, dass der Dummy-Wafer und der auf dem Suszeptor aufliegende Ring, der üblicherweise aus Siliziumcarbid besteht und somit eine geringe Masse aufweist, aneinanderhaften. Dies hat zur Folge, dass der Ring zusammen mit dem Wafer aus dem Reaktor entladen wird. Um den ungewollt aus der Prozesskammer entladenen Ring wieder auf dem Suszeptor platzieren zu können, muss die Prozesskammer geöffnet, der Ring eingebracht, die Prozesskammer wieder verschlossen und die verschlossene Prozesskammer gründlich gereinigt werden.

Somit ist die Anhaftung des Rings an den Dummy-Wafer und die damit einhergehende Entladung des Rings mit einem erheblichen Aufwand und einem großen Verlust an Produktionszeit verbunden.

Die DE 10 2012 215 676 A1 löst dieses Problem dadurch, dass eine Relativbewegung zwischen Träger und Halbleiterscheibe herbeigeführt wird. Die Relativbewegung wird erzeugt, indem der Träger angeregt wird, mechanische Schwingungen auszuführen. Die auf dem Träger liegende Halbleiterscheibe folgt der Schwingungsbewegung des Trägers aufgrund ihrer trägen Masse nicht. Dadurch verändert sich die Lage der Halbleiterscheibe relativ zur Lage des Trägers, und eine noch schwache Verbindung zwischen der Halbeiterscheibe und dem Träger wird gelöst. Jedoch kann die Relativbewegung wichtige Parameter wie die Dicke der abgeschiedenen Schicht und den elektrischen Widerstand beeinflussen.

Aufgabe der vorliegenden Erfindung ist die Bereitstellung eines Suszeptors, der einerseits die Ausbildung von thermischen Spannungen während Vorbehandlung und Abscheidung und andererseits die ungewollte Entladung des auf dem Suszeptor aufliegenden Rings verhindert.

Erfindungsgemäß wird die Aufgabe gelöst durch einen Suszeptor für eine Vorrichtung zum Abscheiden einer Schicht aus Halbleitermaterial auf einer Substratscheibe mittels Abscheidung aus der Gasphase, wobei
der Suszeptor eine Suszeptorplatte und einen Trägerring für eine Substratscheibe umfasst, und
der Trägerring auf die Suszeptorplatte angeordnet ist,
dadurch gekennzeichnet, dass zwischen dem Trägerring und der Suszeptorplatte eine reversibel herstellbare und lösbare mechanische Verbindung besteht.

Bevorzugte Ausführungsformen der vorliegenden Erfindung sind Gegenstand der abhängigen Ansprüche.

### Kurzbeschreibung der Figuren

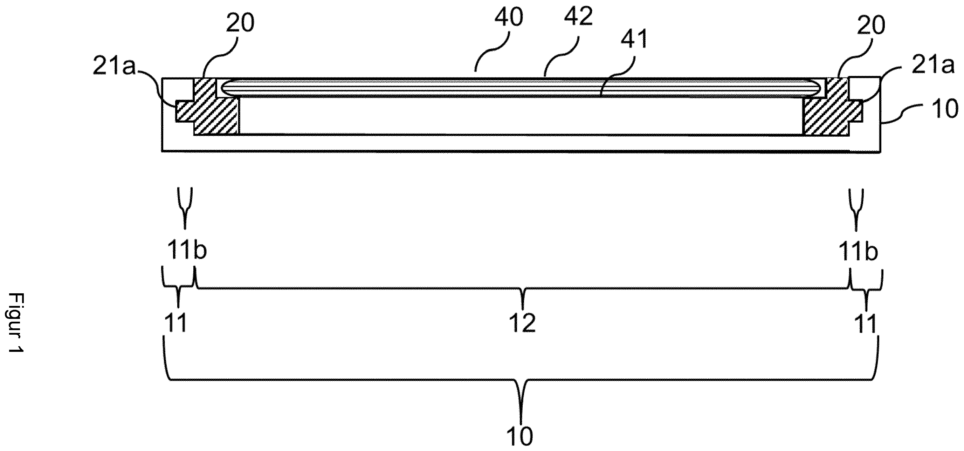

**Figur 1** zeigt einen Schnitt in radialer Richtung einer Ausführungsform eines Suszeptors mit erfindungsgemäßen Merkmalen. Der Suszeptor umfasst eine Suszeptorplatte (10) und einen Trägerring (20) für eine Substratscheibe (40). Die Suszeptorplatte (10) umfasst eine kreisscheibenförmige Bodenplatte (12) und eine ringförmige Stufe (11) am äußeren Rand der Bodenplatte. Die ringförmige Stufe weist an ihrer Innenseite nutförmige Ausfräsungen (11b) auf. Der Trägerring (20) hat an seiner Außenseite Auskragungen (21a), die zur Herstellung der mechanischen Verbindung in die nutförmigen Ausfräsungen (11b) eingeführt werden.

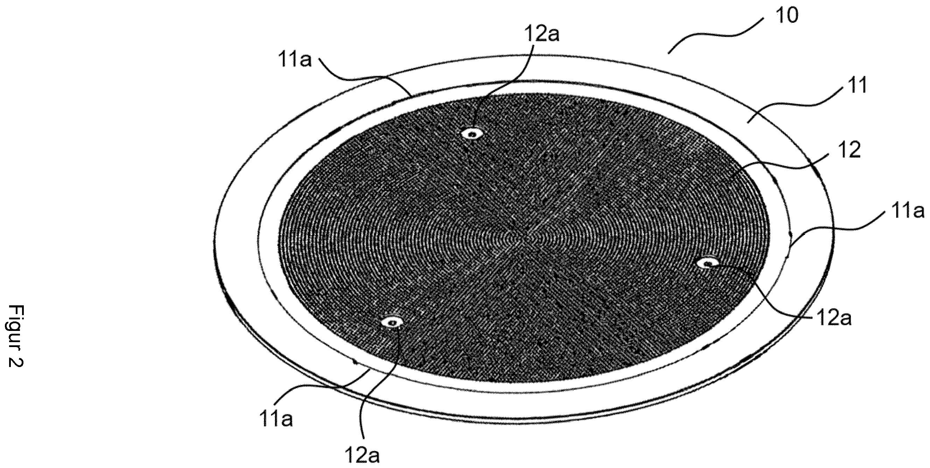

**Figur 2** zeigt eine Suszeptorplatte (10) eines erfindungsgemäßen Suszeptors. Die Suszeptorplatte (10) umfasst eine kreisscheibenförmige Bodenplatte (12) und eine ringförmige Stufe (11) am äußeren Rand der Bodenplatte. Die ringförmige Stufe weist an ihrer Innenseite Aussparungen (11a) auf, in die die Auskragungen des Trägerrings eingelegt werden können. Außerdem weist die kreisscheibenförmige Bodenplatte (12) mehrere konzentrisch angeordnete, kreisförmige Öffnungen (12a) für die Führung von Haltestiften zum Heben und Senken der Halbleiterscheibe auf.

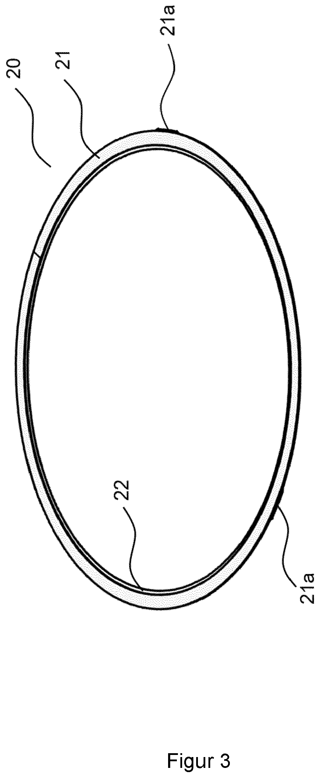

**Figur 3** zeigt einen Trägerring (20) eines erfindungsgemäßen Suszeptors. Der Trägerring umfasst an seiner Innenseite eine Ablagefläche (22) zum Ablegen einer Halbleiterscheibe und eine an die Ablagefläche (22) angrenzende stufenförmige äußere Begrenzung (21). Der Trägerring hat an seiner Außenseite Auskragungen (21a).

### Detaillierte Beschreibung der Erfindung

Der erfindungsgemäße Suszeptor umfasst eine Suszeptorplatte und einen Trägerring für eine Substratscheibe, wobei der Trägerring auf der Suszeptorplatte angeordnet ist, dadurch gekennzeichnet, dass zwischen dem Trägerring und der Suszeptorplatte eine reversibel herstellbare und lösbare mechanische Verbindung besteht.

Der erfindungsgemäße Suszeptor ist vorzugsweise für Substratscheiben mit einem Durchmesser von 150 bis 300 mm, besonders bevorzugt 150 bis 200 mm, am meisten bevorzugt 300 mm, geeignet. Die Substratscheibe ist vorzugsweise eine Halbleiterscheibe aus einkristallinem Silizium, Germanium, Siliziumcarbid oder Galliumnitrid.

Durch die mechanische Verbindung von Suszeptorplatte und Trägerring kann aufgrund der höheren Masse das Anhaften des Rings an den Wafer und damit die ungewollte Entladung aus der Prozesskammer vermieden werden.

Gleichzeitig ist es aufgrund der reversibel herstellbaren und lösbaren mechanischen Verbindung von Trägerring und Suszeptor möglich, diese getrennt zu fertigen und einer unterschiedlichen Oberflächenbehandlung zu unterziehen. Dies ermöglicht insbesondere die Oberflächenqualität des Trägerrings durch ein spezielles Oberflächen-Finishing weiter zu verbessern. So können Trägerring und Suszeptorplatte getrennt voneinander beschichtet und bearbeitet werden, so dass beispielsweise unterschiedliche Rauheiten der Oberflächen von Trägerring und Suszeptorplatte erreicht werden können. Außerdem können so Verbindungsflächen mit noch geringeren Rauheitswerten gefertigt werden. Das Oberflächen-Finishing kann beispielsweise erfolgen durch Polieren, Sandstrahlen, Gleitschleifen, Infiltrieren, Versiegeln, Verschleifen, Galvanisieren, Beschichten und mechanisches Nachbearbeiten. Diese ermöglicht unter anderem, die Rauheit der Ablagefläche zum Ablegen einer Halbleiterscheibe zu verringern. Diese Ablagefläche des Trägerrings stellt die Dichtfläche zur Halbleiterscheibe dar.

Außerdem ist durch die reversibel herstellbare und lösbare mechanische Verbindung eine Anpassung des Trägerrings an verschiedene Prozessbedingungen möglich, ohne dass ein Austausch des Suszeptors insgesamt nötig ist. Auch der Verschleiß oder Defekt eines der beiden Bauteile kann so einfacher und wirtschaftlicher behoben werden, ohne dass ein Komplettaustausch des Suszeptors insgesamt nötig ist.

Des Weiteren ist es möglich, unterschiedliche Werkstoffe für die Suzeptorplatte einerseits und den Trägerring andererseits zu verwenden, wobei die unterschiedlichen Werkstoffe vorzugsweise einen möglichst gleichen Wärmeausdehnungskoeffizient aufweisen sollten.

Besonders bevorzugt besteht der Trägerring aus Siliciumcarbid oder aus mit Siliciumcarbid beschichtetem Graphit. Die Suszeptorplatte eines erfindungsgemäßen Suszeptors besteht vorzugsweise aus Graphit, Graphit-Filz, oder Siliziumcarbid oder aus einem mit Siliziumcarbid beschichteten Material. Das mit Siliziumcarbid beschichtete Material ist bevorzugt Graphit, Graphit-Filz, oder Silizium. Der Trägerring und die Suszeptorplatte können aus demselben oder verschiedenen Materialien bestehen. In einer besonders bevorzugten Ausführungsform besteht der Trägerring aus Siliziumcarbid und die Suszeptorplatte aus mit Siliziumcarbid beschichteten Graphit oder Graphit-Filz.

Die Suszeptorplatte ist bevorzugt kreisscheibenförmig und hat einen größeren Durchmesser als die Substratscheibe. Die Suszeptorplatte umfasst vorzugsweise eine kreisscheibenförmige Bodenplatte und eine ringförmige Stufe am äußeren Rand der Bodenplatte. Die kreisscheibenförmige Bodenplatte der Suszeptorplatte ist vorzugsweise nach innen gewölbt. Besonders bevorzugt hat die Bodenplatte eine konkav-konvexe oder plan-konkave Form.

Die Suszeptorplatte kann eine gasdurchlässige Struktur umfassen. Die gasdurchlässige Struktur der Suszeptorplatte kann erreicht werden durch Verwendung eines porösen, gasdurchlässigen Materials und/oder durch die Ausgestaltung der Bodenplatte mit Löchern, die in axialer Richtung oder schräg zur axialen Richtung verlaufen. Die Löcher in der Bodenplatte haben vorzugsweise einen Durchmesser von 2 mm oder weniger, besonders bevorzugt 1 mm oder weniger und am meisten bevorzugt 0.6 mm oder weniger. Die Löcher in der Bodenplatte haben vorzugsweise einen Durchmesser von 0.1 mm oder mehr. Die Löcher können kreisrund, oval oder eckig ausgestaltet sein. In einer bevorzugten Ausführungsform ist die Bodenplatte der Suszeptorplatte mit kreisrunden Löchern ausgestaltet, die einen einheitlichen Durchmesser im Bereich von 0.1 bis 1.0 mm haben. In einer besonders bevorzugten Ausführungsform hat die kreisscheibenförmige Bodenplatte der Suszeptorplatte eine nach innen gewölbte, vorzugsweise konkav-konvexe oder plan-konkave Form und weist Löcher mit einem Durchmesser von 0.1 bis 0.6 mm auf.

Die Suszeptorplatte weist vorzugsweise mehrere, besonders bevorzugt drei, konzentrisch angeordnete, kreisförmige Öffnungen für die Führung von Haltestiften zum Heben und Senken der Halbleiterscheibe auf. Die Öffnungen sind bevorzugt in gleichem Abstand zueinander und in gleichem Abstand vom Kreismittelpunkt der kreisscheibenförmigen Bodenplatte der Suszeptorplatte angeordnet.

Die reversibel herstellbare und lösbare mechanische Verbindung von Suszeptorplatte und Trägerring ist bevorzugt ein Bajonettverschluss. Bajonettverschlüsse sind allgemein als schnell herstellbare und lösbare mechanische Verbindungen zweier zylindrischer Teile in ihrer Längsachse (axiale Richtung) bekannt. Die jeweiligen Teile können durch Ineinanderstecken und entgegengesetztes Drehen verbunden und auch wieder getrennt werden. Der Bajonettverschluss umfasst besonders bevorzugt ein Aufnahmeteil und ein Einsatzteil. Die Suszeptorplatte bildet vorzugsweise das Aufnahmeteil und der Trägerring vorzugsweise das Einsatzteil des Bajonettverschlusses. In einer anderen Ausführungsform des erfindungsgemäßen Suszeptors kann aber auch der Trägerring das Aufnahmeteil und die Suszeptorpplatte das Einsatzteil des Bajonettverschlusses bilden.

Die Suszeptorplatte eines erfindungsgemäßen Suszeptors umfasst vorzugsweise eine kreisscheibenförmige Bodenplatte und eine ringförmige, umlaufende Stufe am äußeren Rand der Bodenplatte, wobei die ringförmige Stufe das Aufnahmeteil und der Trägerring das Einsatzteil des Bajonettverschlusses bildet. In einer besonders bevorzugten Ausführungsform weist die Innenseite der ringförmigen, umlaufenden Stufe der Suszeptorplatte Aussparungen in Radialinwärtsrichtung und an die Aussparungen angrenzende nutförmige Ausfräsungen auf. Die nutförmigen Ausfräsungen verlaufen entlang der Innenseite der Stufe parallel zur Ringebene der ringförmigen Stufe und sind so ausgestaltet, dass sie zur Führung der Auskragungen des Trägerrings geeignet sind.

Der Trägerring weist vorzugsweise radiale Auskragungen an seiner Außenseite auf. Die radialen Auskragungen sind vorzugsweise so dimensioniert, dass sie beim Aufsetzten des Trägerrings auf die Suszeptorplatte in die Aussparungen an der ringförmigen Stufe der Suszeptorplatte passen, so dass der Trägerring in die Suszeptorplatte eingesetzt werden kann, und die Auskragungen durch Drehen des eingesetzten Trägerrings von den Aussparungen in die angrenzenden nutförmigen Ausfräsungen an der Innenseite der ringförmigen Stufe geführt werden können und so der Bajonettverschluss verschlossen werden kann.

Der Trägerring kann eine Ablagefläche (ledge) zum Ablegen einer Halbleiterscheibe im Randbereich der Rückseite der Halbleiterscheibe und eine an die Ablagefläche angrenzende stufenförmige äußere Begrenzung umfassen. Der Trägerring kann also aus einem radialinwärtsliegenden Sims zur Randauflage der Halbleiterscheibe und einer radialauswärtsliegenden, umlaufenden Stufe bestehen.

Der Innendurchmesser des Trägerrings ist vorzugsweise kleiner und der Außendurchmesser des Trägerrings größer ist als der Durchmesser der Halbleiterscheibe, für die der Suszeptor ausgelegt ist. Vorzugsweise entspricht der minimale Außendurchmesser des Trägerrings, also der Außendurchmesser ohne Berücksichtigung der Auskragungen, dem Innendurchmesser der ringförmigen Stufe am äußeren Rand der Bodenplatte der Suszeptorplatte.

Vorzugsweise ist die axiale Dicke der radialen Auskragungen des Trägerrings geringer als die axiale Ausdehnung der nutförmigen Ausfräsungen an der ringförmigen Stufe der Suszeptorplatte, so dass die Auskragungen in die nutförmigen Vertiefungen eingeführt werden können. Die radiale Ausdehnung der Auskragungen des Trägerrings ist vorzugsweise ebenfalls geringer als die radiale Ausdehnung der nutförmigen Ausfräsungen an der ringförmigen Stufe der Suszeptorplatte. Die radiale Ausdehnung der Auskragungen entspricht dabei der Differenz des größten und des geringsten Durchmessers des Trägerrings in radialer Richtung, beziehungsweise, wenn die Auskragungen in radialer Richtung einander gegenüberliegen, der Hälfte dieser Differenz.

Die reversibel herstellbare und lösbare mechanische Verbindung zwischen dem Trägerring und der Suszeptorplatte, bei der es sich bevorzugt um einen Bajonettverschluss handelt, wird hergestellt durch
Einsetzten des Trägerrings in die ringförmige, umlaufende Stufe der Suszeptorplatte, indem die Auskragungen des Trägerrings mit den Aussparungen der ringförmigen Stufe der Suszeptorplatte in axialer Blickrichtung zur Deckung gebracht werden, und
Drehen des Trägerrings um den Ringmittelpunkt relativ zur Suszeptorplatte, so dass die Auskragungen von den Aussparungen in die angrenzenden nutförmigen Ausfräsungen der ringförmigen Stufe der Suszeptorplatte geführt werden.

Der Bajonettverschluss ist vorzugsweise verriegelbar. In einer besonders bevorzugten Ausführungsform umfasst die Verriegelung des Bajonettverschlusses einen Stift und eine Bohrung im Aufnahmeteil des Bajonettverschlusses. In einer bevorzugten Ausführungsform verläuft die Bohrung dabei in axialer Richtung so, dass durch Einstecken des Stiftes in die Bohrung eine nutförmige Ausfräsung oder eine Aussparung so blockiert wird, dass eine zuvor in eine Ausfräsung eingeführte Auskragung des Trägerrings nicht mehr bewegt werden kann. Dadurch wird eine Verschiebung des Trägerringes insgesamt verhindert und der Bajonettverschluss somit blockiert.

Der Trägerring hat vorzugsweise einen arithmetischen Mittenrauwert Ra von 0,1 bis 2, bevorzugt 0,2 bis 1,6 und am meisten bevorzugt 0,4 bis 1,2. Beim Mittenrauwert Ra handelt es sich um den rechnerischen Mittelwert aller Abweichungen des Rauheitsprofils von der mittleren Linie entlang der Bezugsstrecke. Beispielsweise hat die Ablagefläche des Trägerrings, auf der die Halbleiterscheibe abgelegt wird, bevorzugt einen arithmetischen Mittenrauwert Ra von 0,1 bis 0,8.

Der Mittenrauwert kann beispielsweise mittels eines Lasers bestimmt werden, beispielsweise mit einem Gerät des Herstellers Chapman Instrument Inc. Dabei wird die Oberfläche auf einer definierten Messstrecke abgetastet und sämtliche Höhen- und Tiefenunterschiede der Oberfläche aufgezeichnet. Die Rauheitsmessung kann nach DIN EN ISO 4288-1998 erfolgen.

Außerdem ist Gegenstand der Erfindung ein Verfahren zum Abscheiden einer Schicht aus Halbleitermaterial auf einer Substratscheibe, dadurch gekennzeichnet, dass der erfindungsgemäße Suszeptor verwendet wird. Vorzugsweise wird dabei eine epitaktische Schicht aus Halbleitermaterial abgeschieden.

Durch die mechanische Verbindung von Suszeptorplatte und Trägerring kann aufgrund der höheren Masse das Anhaften des Trägerrings an einen Test-Wafer (Dummy-Wafer) verhindert und damit dessen ungewollte Entladung aus der Prozesskammer vermieden werden. Deshalb können bei Verwendung des erfindungsgemäßen Suszeptors solche Test-Wafer regelmäßig in kürzeren Intervallen zum Einsatz gebracht werden. Dies führt zu einer verbesserten Prozesskontrolle, Prozessanpassung und Prozessüberwachung.

Die im erfindungsgemäßen Verfahren verwendete Substratscheibe ist vorzugsweise eine Halbleiterscheibe aus einkristallinem Silizium und hat einen Durchmesser von 150 bis 300 mm, besonders bevorzugt 150 bis 200 mm, am meisten bevorzugt 300 mm.

Das auf der Substratscheibe abgeschiedene Halbleitermaterial ist vorzugsweise Silizium, Germanium, eine Legierung dieser Elemente, oder ein III/V-Halbleitermaterial, besonders bevorzugt Galliumnitrid. Das Halbleitermaterial ist bevorzugt eine unter Normaldruck oder Niederdruck epitaktisch abgeschiedene Schicht aus einkristallinem Silizium oder einkristallinem Galliumnitrid. Die Abscheidetemperatur für die Abscheidung einer Schicht aus einkristallinem Silizium beträgt vorzugsweise 900 bis 1300 °C, besonders bevorzugt 1080 bis 1150 °C. Die Abscheidetemperatur für die Abscheidung einer Schicht aus einkristallinem Galliumnitrid beträgt vorzugsweise 100 bis 1000 °C, besonders bevorzugt 600 bis 900°C und am meisten bevorzugt 700 bis 850 °C.

Das Prozessgas zur Abscheidung einer siliziumhaltigen Schicht aus Halbleitermaterial aus der Gasphase umfasst ein Chlorsilan und Wasserstoff und kann optional ein Dotierungsgas enthalten. Das Chlorsilan ist mindestens eine Verbindung ausgewählt aus der Gruppe aus Monochlorsilan, Dichlorsilan, Trichlorsilan und Tetrachlorsilan. Das Prozessgas zur Abscheidung einer Galliumnitrid-Schicht umfasst eine Gallium-Verbindung und eine Stickstoffverbindung und kann optional ein Dotierungsgas enthalten. Die Gallium-Verbindung ist vorzugsweise eine Tiralkylgallium-Verbindung oder eine Trihalogengallium-Verbindung, vorzugsweise Trimethylgallium, Triethylgallium oder Trichlorgallium. Die Stickstoff-Verbindung ist vorzugsweise Ammoniak. Das Dotierungsgas umfasst mindestens eine Verbindung ausgewählt aus kohlestoffhaltigen Verbindungen, eisenhaltigen Verbindungen, Diboran (B₂H₆), Monophosphan (PH₃) und Monoarsan (AsH₃).

### Detaillierte Beschreibung erfindungsgemäßer Ausführungsbeispiele

Ein Dummy-Wafer aus einkristallinem Silizium mit einem Durchmesser von 300 mm wurde in einem Einzelscheibenreaktor mit einer epitaktischen Schicht aus Silizium unter Verwendung eines erfindungsgemäßen Suszeptor beschichtet.

Der verwendete Suszeptor bestand aus einer Suszeptorplatte und einen Trägerring, die mittels eines Bajonettverschlusses verbunden wurden. Der Trägerring wies an seiner Innenseite eine Ablagefläche zum Ablegen des Wafers und eine an die Ablagefläche angrenzende stufenförmige äußere Begrenzung auf. Die Suszeptorplatte bestand aus einer kreisscheibenförmigen, nach innen gewölbten, plan-konkave Bodenplatte und einer ringförmigen Stufe am äußeren Rand der Bodenplatte, wobei die Innenseite der ringförmigen, umlaufenden Stufe der Suszeptorplatte Aussparungen und an die Aussparungen angrenzende nutförmige Ausfräsungen aufweist, die entlang der Innenseite der Stufe verliefen. Der Bajonettverschluss wurde erzeugt durch Einsetzten des Trägerrings in die ringförmige, umlaufende Stufe der Suszeptorplatte, indem die Auskragungen des Trägerrings mit den Aussparungen der ringförmigen Stufe der Suszeptorplatte zur Deckung gebracht wurden, und durch anschließendes Drehen des Trägerrings um den Ringmittelpunkt relativ zur Suszeptorplatte, wobei die Auskragungen von den Aussparungen in die angrenzenden Einfräsungen geführt wurden. Der Trägerring bestand aus Siliziumcarbid. Die Ablagefläche zum Ablegen der Halbleiterscheibe auf dem Trägerring wies einen arithmetischen Mittenrauwert Ra von 0,1 bis 0,8 auf.

. Die Suszeptorplatte bestand aus Graphit und wies eine Siliziumcarbid-Beschichtung mit einer Schichtdicke von 100 µm auf.

Die mehrfache Wiederholung des Versuches zeigte, dass keine ungewollte Entnahme des Trägerrings zusammen mit dem Dummy-Wafer erfolgte.

## Patentansprüche

1. Suszeptor für eine Vorrichtung zum Abscheiden einer Schicht aus Halbleitermaterial auf einer Substratscheibe mittels Abscheidung aus der Gasphase, wobei
der Suszeptor eine Suszeptorplatte (10) und einen Trägerring (20) für eine Substratscheibe (40) umfasst, und
der Trägerring (20) auf der Suszeptorplatte (10) angeordnet ist,
**dadurch gekennzeichnet, dass** zwischen dem Trägerring (20) und der Suszeptorplatte (10) eine reversibel herstellbare und lösbare mechanische Verbindung besteht.

2. Suszeptor gemäß dem Anspruch 1, **dadurch gekennzeichnet, dass** die reversibel herstellbare und lösbare mechanische Verbindung ein Bajonettverschluss umfassend ein Aufnahmeteil und ein Einsatzteil ist.

3. Suszeptor gemäß dem Anspruch 2, **dadurch gekennzeichnet, dass**
die Suszeptorplatte (10) eine kreisscheibenförmige Bodenplatte (12) und eine ringförmige Stufe (11) am äußeren Rand der Bodenplatte (12) umfasst,
die ringförmige Stufe (11) am äußeren Rand der Bodenplatte (12) das Aufnahmeteil des Bajonettverschlusses bildet, und
der Trägerring (20) das Einsatzteil des Bajonettverschlusses bildet.

4. Suszeptor gemäß dem Anspruch 3, **dadurch gekennzeichnet, dass**
die Innenseite der ringförmigen Stufe (11) der Suszeptorplatte (10) Aussparungen (11a) und an die Aussparungen (11a) angrenzende nutförmige Ausfräsungen (11b) aufweist, die entlang der Innenseite der ringförmigen Stufe (11) parallel zur Ringebene verlaufen, und
die Außenseite des Trägerrings (20) Auskragungen (21a) aufweist.

5. Suszeptor gemäß dem Anspruch 3 oder 4, **dadurch gekennzeichnet, dass** die reversibel herstellbare und lösbare mechanische Verbindung zwischen dem Trägerring (20) und der Suszeptorplatte (10) hergestellt wird durch
Einsetzten des Trägerrings (20) in die ringförmige, umlaufende Stufe (11) der Suszeptorplatte (10), indem die Auskragungen (21a) des Trägerrings (20) mit den Aussparungen (11a) der ringförmigen Stufe (11) der Suszeptorplatte (10) zur Deckung gebracht werden, und
Drehen des Trägerrings (20) um den Ringmittelpunkt relativ zur Suszeptorplatte (10), so dass die Auskragungen (21a) von den Aussparungen (11a) in die angrenzenden nutförmigen Ausfräsungen (11b) geführt werden.

6. Suszeptor gemäß einem der Ansprüche 2 bis 5, **dadurch gekennzeichnet, dass** der Bajonettverschluss verriegelbar ist.

7. Suszeptor gemäß dem Anspruch 6, **dadurch gekennzeichnet, dass** die Verriegelung des Bajonettverschlusses einen Stift und eine Bohrung im Aufnahmeteil des Bajonettverschlusses umfasst, wobei durch Einstecken des Stiftes in die Bohrung eine Drehbewegung des Einsatzteils relativ zum Aufnahmeteil verhindert wird.

8. Suszeptor gemäß einem der Ansprüche 1 bis 7, **dadurch gekennzeichnet, dass** die Suszeptorplatte (10) eine gasdurchlässige Struktur aufweist.

9. Suszeptor gemäß einem der Ansprüche 1 bis 8, **dadurch gekennzeichnet, dass** der Trägerring (20) aus Siliciumcarbid oder aus mit Siliciumcarbid beschichtetem Graphit besteht.

10. Suszeptor gemäß einem der Ansprüche 1 bis 9, **dadurch gekennzeichnet, dass** die Suszeptorplatte (10) aus mit Siliciumcarbid beschichtetem Graphit oder Graphitfilz besteht.

11. Suszeptor gemäß einem der Ansprüche 1 bis 10, **dadurch gekennzeichnet, dass** ein Innendurchmesser des Trägerrings (20) kleiner und ein Außendurchmesser des Trägerrings (20) größer ist als der Durchmesser der Halbleiterscheibe (40), für die der Suszeptor ausgelegt ist

12. Suszeptor gemäß einem der Ansprüche 1 bis 11, **dadurch gekennzeichnet, dass** die Suszeptorplatte (10) mehrere konzentrisch angeordnete, kreisförmige Öffnungen (12a) für die Führung von Haltestiften zum Heben und Senken der Halbleiterscheibe (40) aufweist.

13. Suszeptor gemäß einem der Ansprüche 3 bis 12, **dadurch gekennzeichnet, dass** die kreisscheibenförmige Bodenplatte (12) der Suszeptorplatte (10) eine nach Innen gewölbte Form aufweist.

14. Suszeptor gemäß einem der Ansprüche 1 bis 13, **dadurch gekennzeichnet, dass** der Trägerring (20) eine Ablagefläche (22) zum Ablegen einer Halbleiterscheibe (40) im Randbereich der Rückseite (41) der Halbleiterscheibe (40) und eine an die Ablagefläche angrenzende stufenförmige äußere Begrenzung (21) umfasst.

15. Verfahren zum Abscheiden einer Schicht aus Halbleitermaterial auf einer Substratscheibe, **dadurch gekennzeichnet, dass** ein Suszeptor gemäß einem der Ansprüche 1 bis 14 verwendet wird.
